# EUROPÄISCHE PATENTSCHRIFT

(11) **EP 2 619 595 B1**
(45) Veröffentlichungstag und Bekanntmachung des Hinweises auf die Patenterteilung: **28.11.2018**
(21) Anmeldenummer: 11778847.1
(22) Anmeldetag: 27.10.2011
(51) Int. Cl.: G01R 11/02, G01R 21/06, G01R 21/133, G01R 15/20

(54) **MESSSYSTEM ZUR ÜBERWACHUNG MINDESTENS EINER PHASE EINES SYSTEMS**
MEASUREMENT SYSTEM FOR MONITORING AT LEAST ONE PHASE OF A SYSTEM
SYSTÈME DE MESURE POUR SURVEILLER AU MOINS UNE PHASE D'UN SYSTÈME

(30) Priorität: 03.11.2010 DE 102010043254
(43) Veröffentlichungstag der Anmeldung: 31.07.2013
(73) Patentinhaber: Siemens Aktiengesellschaft, 80333 München (DE)
(72) Erfinder: BEHRINGER, Klaus, 91338 Igensdorf (DE); MEINKE, Martin, 92224 Amberg (DE)
(86) Internationale Anmeldenummer: PCT/EP2011/068880
(87) Internationale Veröffentlichungsnummer: WO 2012/059398

(56) Entgegenhaltungen:
- WO-A2-2010/007369
- DE-A1- 19 842 241
- US-A1- 2004 155 644
- US-A1- 2006 033 487
- US-A1- 2010 235 122

## Beschreibung

Die Erfindung betrifft ein Messsystem zur Überwachung mindestens einer Phase eines Systems, insbesondere eines Verbraucherabzweigs.

Steigendes Umweltbewusstsein führt zum Anspruch Energieverschwendung in industriellen Anlagen zu vermeiden und speziell auch elektrische Energie effizient zu nutzen. Das hierfür erforderliche "Energiemanagement" benötigt als Eingangsgroße die detaillierte Überwachung der Energieverteilung in der Anlage. Hierbei sind insbesondere die Energieflüsse zu den einzelnen Verbrauchern von Interesse. Die Energiezufuhr zu den einzelnen Verbrauchern erfolgt üblicherweise über eine Leitung (eine Phase) oder drei Leitungen (drei Phasen), je nachdem ob ein 1-phasiger oder 3-phasiger Verbraucher vorliegt.

DE19842241 offenbart einen Stromzähler.

In maschinellen Anlagen mit drehenden Teilen sind Drehstrommotoren die maßgebenden Energieumsetzer. Diese Drehstrommotoren werden über Schalt- und Schutzgeräte üblicherweise über Stichleitungen mit Energie versorgt. Durch die Schalt- und Schutzgeräte erfolgt zudem eine Steuerung sowie Überwachung des an ihm angeschlossenen Drehstrommotors. Die Kombination aus Schalt- und Schutzgerät wird "Verbraucherabzweig" genannt. Sicherungslose Verbraucherabzweige sind beispielsweise Gerätekombinationen, bestehend aus einem Schütz für das betriebsmäßige Schalten und einem Leistungsschalter für den Überlast- und Kurzschlussschutz.

Ein Drehstrommotor wir üblicherweise über drei Leitungen (Phasen) mit elektrischer Energie versorgt. Diese Leitungen (Phasen) werden über den Verbraucherabzweig zu der Anlage geführt, so dass die erwünschte Steuerung und Überwachung der Anlage durch den Verbraucherabzweig erfolgen kann.

Für die Optimierung der Verbrauchswerte einer Anlage (z.B. ein Drehstrommotors) sind insbesondere folgende Faktoren von Bedeutung:
- Transparente Erfassung der Energieverteilung (Wirkleistung, Scheinleistung, Blindleistung) in der Anlage,
- Bereitstellung von Informationen über den jeweiligen Belastungszustand der einzelnen Verbraucherabzweige,
- Einleitung von Steuerungsmaßnahmen (zentral / dezentral) zur Optimierung der Verbraucherabzweigwirkungsgrade, so dass es zu einer Erhöhung der Energieeffizienz der Anlage kommt.

Bei den Steuerungsmaßnahmen ist zu unterscheiden zwischen (i.d.R. zeitkritischen, dezentralen) Wirkungsgrad-Optimierungs-Regelvorgängen im Einzelabzweig (z.B. Drehmomentregelung) und zentral von einem übergeordneten Leitsystem geführten Energiemanagement-Steuerungsvorgängen, z.B. Ab- und Zuschalten einzelner Verbraucherabzweige in Abhängigkeit vom Auslastungsgrad.

Die wichtigste Voraussetzung für ein effektives Energiemanagement ist jedoch die schnelle Erfassung des jeweiligen Belastungszustandes in den einzelnen Verbraucherabzweigen.

Als beste Kenngröße für den Belastungszustandes eines motorischen Verbraucherabzweiges hat sich der Phasenwinkel zwischen Strom und Spannung (CosPhi / cosϕ) erwiesen. Da diese Kenngröße jedoch nicht über alle Motor-Betriebsbereiche zu eindeutigen Ergebnissen führt, muss zusätzlich der jeweils zugehörige Betriebsstrom mit bewertet werden.

Für Verbraucherabzweige besteht zudem ein Anspruch auf Kontrolle des Betriebszustandes der angeschlossenen Anlage (Condition-Monitoring) mittels Überwachung der zeitlichen Veränderung der elektrischen Kenngrößen. Hier ist zwischen langfristigen Verhaltensänderungen (z.B. durch Verschleißerscheinungen) und kurzfristigen Verhaltensänderungen (z.B. Trockenlauf von Pumpen, Keilriemenabwurf bei Transmissionen, Luftstromblockierung bei Lüftern) zu unterscheiden. Langfristige Verhaltensänderungen können über Trendanalysen (z.B. der Stromaufnahme) detektiert werden. Für die Detektion kurzfristiger Verhaltensänderungen sind dagegen schnelle Messwertauswertungen gefordert. Als sinnvolle Kenngröße für die Detektion kurzfristiger Verhaltensänderungen hat sich auch in der Kontrolle des Betriebszustandes (im Condition Monitoring) die Überwachung des cosϕ in Verbindung mit einer Bewertung des zugehörigen Betriebstromes erwiesen.

Verbraucherabzweige müssen auch gegen Überlast und Kurzschluss geschützt werden. Der Überlastschutz kann über eine elektronische Simulation der Motorerwärmung (Motormodell) anhand des zeitlichen Verlaufes des Motorstromes gewährleistet werden. Für den einen "elektronischen" Kurzschlussschutz ist dagegen eine extrem schnelle Grenzwertüberwachung des Motorstromes (Reaktionszeitanforderung = 10 µs) erforderlich.

Für die Erfassung und Auswertung der erforderlichen Messwerte, welche bei eine Optimierung der Verbrauchswerte einer Anlage, der Kontrolle des Betriebszustandes und dem Schutz vor Überlast und Kurzschluss erforderlich sind, sind in einem Verbraucherabzweig, insbesondere in einem 3-phasigen Verbraucherabzweig, bislang aufwändige, aus einer Vielzahl von Komponenten bestehende elektronische Schaltungen (Analogtechnik + Digitaltechnik) erforderlich.

Es ist Aufgabe der vorliegenden Erfindung ein kompaktes und vielfältiges Messsystem zur Ermittlung von Strom- und Spannungswerten mindestens einer Phase bereitzustellen.

Vorzugweise umfasst ein Verbraucherabzweig dieses Messsystem, so dass insbesondere eine Analyse hinsichtlich der Optimierung einer mit dem Verbraucherabzweig verbundenen Anlage, eine Kontrolle des Betriebszustandes der Anlage und eine Überwachung hinsichtlich einer Überlast bzw. eines Kurzschluss der Anlage ermöglicht wird.

Ferner sollte das Messsystem vorzugsweise im Vergleich zu herkömmlichen Mess-Modul-Losung kostenoptimiert sein.

Das Messsystem soll vorzugsweise 1-phasige und/oder 3-phasige Strom- und Spannungswerte erfassen und auswerten können.

Erfindungsgemäß wird eine dieser Aufgaben gelöst durch eine Vorrichtung gemäß Anspruch 1, d.h. durch ein Messsystem zur Überwachung mindestens einer Phase eines Systems, insbesondere eines Verbraucherabzweigs, mit einem auf einer Leiterplatte angeordneten Messmodul, wobei das Messmodul einen Signalerfassungsbaustein und einen Signalweiterverarbeitungsbaustein umfasst und der Signalerfassungsbaustein durch einen ASIC ausgebildet ist, wobei je zu überwachende Phase die Leiterplatte einen Spannungssensor und der Signalerfassungsbaustein Stromsensoren und einen mit dem Spannungssensor elektrisch leitend verbunden Spannungssensoranschluss umfasst, wobei über die Stromsensoren eine Ermittlung eines Stromwertes und über den Spannungssensor eine Ermittlung eines Spannungswertes der zu überwachenden Phase erfolgen kann, wobei der Signalweiterverarbeitungsbaustein mit dem Signalerfassungsbaustein verbunden ist und ermittelte Strom- und Spannungswerte auswerten kann, wobei der Signalweiterverarbeitungsbaustein Ausgabemittel umfasst, mit welchen serielle Daten und digitale Signale für Steuerungszwecke ausgebbar sind. Vorteilhafte Weiterbildungen der Erfindung sind in den abhängigen Ansprüchen 2 bis 16 angegeben.

Das System ist vorzugsweise ein Verbraucherabzweig, welcher die mindestens eine Phase umfasst. Die mindestens eine Phase dient vorzugsweise der Energieversorgung einer mit dem Verbraucherabzweig verbundnen Anlage oder spiegelt einen der Energieversorgung der mit dem Verbraucherabzweig verbunden Anlage charakterisierenden Wert wieder.

Mittels der Stromsensoren kann der entsprechende Stromwert, d.h. ein den Strom der entsprechenden Phase charakterisierender Wert, der zu überwachenden Phase (Leitung) bzw. der zu überwachenden Phasen (Leitungen) ermittelt werden. Bei einer Überwachung mehrerer Phasen können vorzugsweise einzelne Stromsensoren der Ermittlung eines Stromwertes mehrerer Phasen dienen. Zur Ermittlung eines Stromwertes einer Phase werden insbesondere mindestens zwei Stromsensoren benötigt.

Über den Spannungssensoranschluss kann der Spannungssensor bzw. können die Spannungssensoren (sofern mehrere Phasen überwacht werden) mit dem Signalerfassungsbaustein verbunden werden. Hierbei sind vorzugsweise je zu überwachende Phase ein Spannungssensor und ein Spannungssensoranschluss vorgesehen, wobei der Spannungssensor elektrisch leitend mit dem zugehörigen Spannungssensoranschluss verbunden ist. Durch den/die Spannungssensor/-en kann der entsprechende Spannungswert, d.h. ein die Spannung der Phase charakterisierender Wert, der zu überwachenden Phase (Leitung) bzw. der zu überwachenden Phasen (Leitungen) ermittelt werden. Der Spannungssensor ist vorzugsweise ein kapazitiver Spannungssensor. Durch mehrere in der Leiterplatte integrierte kapazitive Spannungssensoren kann eine galvanisch getrennte kapazitive Spannungsmessung eines Mehrleitersystems erfolgen. Hierfür werden keine MEMS-Strukturen (MEMS = Micro-Electro-Mechanical System) verwendet. Dem Signalerfassungsbaustein kann somit der Spannungswert der zu überwachenden Phase durch den Spannungssensor über den zugehörigen Spannungssensoranschluss zugeführt werden.

Über das Ausgabemittel sind serielle Daten, insbesondere Strom-, Spannungs-, Leistungs- und Diagnosewerte, und digitale Signale für Steuerungszwecke, insbesondere Signale, welche einen Kurzschluss, eine Überlast und einen Phasennulldurchgang des Stroms und der Spannung hinsichtlich der überwachten mindestens einen Phase charakterisieren, ausgebbar. Das Ausgabemittel weist zur Ausgabe der seriellen Daten und/oder digitalen Signale vorzugsweise jeweils einen wert-/ signalspezifischen Anschluss auf.

Über die mindestens eine Phase des Systems erfolgt vorzugsweise die Energiezufuhr einer mit dem System verbundenen Anlage. Durch das erfindungsgemäße Messsystem wird ein kompaktes Messsystem bereitgestellt, mit welchem eine optimale Überwachung mindestens einer Phase des Systems ermöglicht wird. Durch das Messsystem können insbesondere die relevanten Strom- und Spannungswerte des Systems über die mindestens eine überwachte Phase ermittelt werden. Anhand einer Auswertung der zeitlichen Verläufe der Strom- und/oder Spannungswerte können weitere wichtige Daten ermittelt werden. Vorzugsweise können die Phasennulldurchgänge von Strom und Spannung hinsichtlich der überwachten Phase/-n durch das Messsystem ermittelt werden. Auf diese Weise können mit nur einem Messsystem sowohl Steuer- und Regelvorgänge im Energiemanagement und im Condition Monitoring sowie ein Motorschutz (Überlastschutz, Kurzschlussschutz) bezüglich der durch die mindestens eine Phase mit Energie versorgte Anlage realisiert werden. Ferner können über das Messsystem vorzugsweise Leistungsdaten wie z.B. die Wirkleistung, die Scheinleistung, die Blindleistung und/oder der CosPhi (cosϕ) hinsichtlich der überwachten mindestens einen Phase ausgegeben werden. Das erfindungsgemäße Messsystem bietet ein breites Einsatzspektrum, so dass es vielfältig eingesetzt werden kann und somit eine produktspezifische Mess-Modul-Lösung entfallen kann. Durch das Messsystem kann insbesondere eine extrem schnelle Stromgrenzüberwachung mit zugehöriger Signalausgabe erfolgen, welche eine Reaktionszeit von ca. 10ps ermöglicht. Durch die im Messsystem integrierten Detektion der Phasennulldurchgänge von Strom und Spannung und einer zugehörigen phasenlagentreuen digitalen Signalausgabe kann eine extrem schnelle CosPhi-Berechnung erfolgen.

Die Analyse der Strom- und Spannungswerte erfolgt vorzugsweise im Signalweiterverarbeitungsbaustein, welcher vorzugsweise einen Mikrokontroller umfasst. Durch den zweigeteilten Aufbau kann das Messmodul ferner optimal auf die jeweilige Anwendung abgestimmt werden. In Abhängigkeit des Anwendungsfalls kann der Signalweiterverarbeitungsbaustein ausgewählt und letztendlich mit dem Signalerfassungsbaustein gekoppelt werden. Der analoge Teil des Messmoduls (Signalerfassungsbaustein) kann somit mit verschiedenen leistungsfähigen digitalen Signalweiterverarbeitungsbausteinen kombiniert werden.

In einer vorteilhaften Ausführungsform der Erfindung ist das System einer Anlage vorgeschaltet und die durch das System "geschleifte" mindestens eine Phase dient der Energieversorgung der nachgeschalteten Anlage oder spiegelt die Energieversorgung der nachgeschalteten Anlage wieder. Das System ist beispielsweise ein Verbraucherabzweig, welcher der Anlage, wie beispielsweise einem Elektromotor, vorgeschaltet ist. Durch das im System (im Verbraucherabzweig) integrierte Messsystem, kann eine Überwachung der mindestens einen Phase und hierdurch eine Überwachung der nachgeschalteten Anlage erfolgen. Alternativ hierzu ist es ebenso denkbar, dass das System ein Endverbraucher (eine Anlage) ist, wie z.B. ein Elektromotor. Die zu überwachende mindestens eine Phase dient folglich unmittelbar der Energieversorgung des Systems, so dass durch das Messsystem das System direkt überwacht und analysiert wird.

In einer weiteren vorteilhaften Ausführungsform der Erfindung sind die Stromsensoren durch im ASIC integrierte Stromerfassungs-Hallsensoren ausgebildet.

In einer weiteren vorteilhaften Ausführungsform der Erfindung ist der mindestens eine Spannungssensor außerhalb des von dem Signalerfassungsbaustein überdeckten Bereichs der Leiterplatte angeordnet. Der Spannungssensor ist somit in der Draufsicht auf den Signalerfassungsbaustein und die Leiterplatte außerhalb des von dem Signalerfassungsbaustein überdeckten Bereichs der Leiterplatte angeordnet, so dass er nicht von der Fläche des Signalerfassungsbausteins überdeckt wird. Durch den Spannungssensor geführte orthogonal zur Leiterplatte ausgerichtete Gerade schneidet somit nicht den Signalerfassungsbaustein. Auf diese Weise kann insbesondere eine fertigungs- und verschaltungstechnisch verbesserte Bauform ermöglicht werden. Der mindestens eine Spannungssensor ist jeweils mit dem zugehörigen Spannungssensoranschluss verbunden. Dadurch, dass der Spannungssensor außerhalb des von dem Signalerfassungsbaustein überdeckten Bereichs der Leiterplatte angeordnet ist, kann eine flexible Phasenführung ermöglicht werden. Der Spannungssensor muss lediglich im Bereich seiner zu überwachenden Phase platziert werden, so dass eine Ermittlung des Spannungswertes der Phase erfolgen kann. Dieser Spannungswert kann über die elektrisch leitende Verbindung zwischen dem Spannungssensor und dem Signalerfassungsbaustein dem Signalerfassungsbaustein zugeführt werden. Auf diese Weise kann zwischen dem mindestens einen Spannungssensor und den Stromsensoren eine räumliche Distanz hergestellt werden, so dass sie sich gegenseitig nicht stören. Die Stromsensoren und der mindestens eine Spannungssensor sind somit derart angeordnet, dass ein Strom- und Spannungswert hinsichtlich der mindestens einen Phase ermittelbar ist.

In einer weiteren vorteilhaften Ausführungsform der Erfindung ist der mindestens eine Spannungssensor innerhalb der Leiterplatte angeordnet. Der mindestens eine Spannungssensor wird folglich von der Leiterplatte umschlossen. Auf diese Weise kann ein äußerst kompaktes Messsystem realisiert werden. Ferner kann durch das Integrieren des mindestens einen Spannungssensors innerhalb der Leiterplatte eine optimierte Koppelung des mindestens einen Spannungssensors mit der mindestens einen Phase und dem Signalerfassungsbaustein erfolgen.

In einer weiteren vorteilhaften Ausführungsform der Erfindung ist der Spannungssensor ein kapazitiver Spannungssensor.

In einer weiteren vorteilhaften Ausführungsform der Erfindung ist die mindestens eine zu überwachende Phase des zu überwachenden Systems jeweils galvanisch getrennt von ihren Stromsensoren und ihrem Spannungssensoranschluss, insbesondere ihrem Spannungssensor. Auf diese Weise können die Anforderungen an die Sicherheit des Messsystems erfüllt werden.

In einer weiteren vorteilhaften Ausführungsform der Erfindung ist das Messsystem zur Überwachung eines mindestens dreiphasigen Systems ausgebildet. Bei der Überwachung eines Mehrleitersystems sind vorzugsweise je Phase durch den ASIC ausgebildete Stromsensoren und ein Spannungssensoranschluss, sowie ein Spannungssensor vorgesehen. Vorzugsweise weist ferner das Ausgabemittel für phasenspezifische Werte/Signale jeweils einen separaten Ausgang auf.

Bei einer Überwachung eines dreiphasigen Systems (System mit drei Leitungen) umfasst das Messsystem folglich mindestens vier Stromsensoren, drei Spannungssensoranschlüsse und drei Spannungssensoren, so dass hierüber die Stromerfassung und Spannungserfassung des Mehrleitersystems erfolgen kann. Der einzelne Spannungssensoranschluss der Spannungssensoranschlüsse ist jeweils mit seinem zugehörigen phasenspezifischen Spannungssensor verbunden. Folglich sind mindestens drei Spannungssensoren auf der Leiterplatte aufgebracht bzw. in der Leiterplatte integriert. Die einzelnen Stromsensoren und/oder Spannungssensoren sind vorzugsweise deaktivierbar. Erfolgt beispielsweise lediglich eine Überwachung einer Phase mit dem Messsystem, welches mehrere Phasen überwachen kann, so können die nichtgenutzten Stromsensoren und Spannungssensoren deaktiviert werden.

Sofern mit dem Messsystem eine Überwachung mehrerer Phasen erfolgt, werden vorzugsweise die Phasen bei einer Draufsicht auf das Signalerfassungsbaustein und die Leiterplatte im Bereich des Signalerfassungsbausteins gebündelt geführt und außerhalb des Signalerfassungsbausteins vorzugsweise innerhalb der Leiterplatte oder innerhalb eines Isolierblocks mit einem weiteren Abstand zueinander geführt.

In einer weiteren vorteilhaften Ausführungsform der Erfindung umfasst das Messmodul, insbesondere der Signalerfassungsbaustein, mindestens ein Anschlussmittel zum Anschließen eines externen Stromsensors zur Ermittlung eines Stromwertes der mindestens einen Phase des Systems. Das Messmodul weist vorzugsweise mehrere Anschlussmittel auf, so dass je zu überwachende Phase des Systems ein Anschlussmittel vorhanden ist. Durch das Anschlussmittel kann ein externer Stromsensor zur Ermittlung des Stroms, wie beispielsweise ein Stromwandler, eine Rogowskispule oder ein Shunt, mit dem Signalerfassungsbaustein gekoppelt werden.

Ebenso ist es denkbar, dass je Phase ein externer Spannungssensor mit dem Messmodul und insbesondere dem Signalerfassungsbaustein koppelbar ist, so dass eine alternative Spannungserfassung je Phase erfolgen kann.

Auf diese Weise kann eine Stromerfassung und/oder Spannungserfassung mittels externer Stromsensoren und/oder des externen Spannungssensors (bzw. der externen Spannungssensoren bei mehreren zu überwachenden Phasen) ermöglicht werden. Das Messmodul kann folglich für Strom- und Spannungsmessungen in anderen Strom- und Spannungsbereichen verwendet werden. Vorzugsweise werden durch die Anschlussmittel mehrere Anschlussstellen für die externe Stromsonoren und/oder externen Spannungssensoren gebildet, so dass eine Überwachung eines Mehrleitersystems, insbesondere eines drei Phasen-Systems, rein durch die externen Strom- und/oder externen Spannungssensoren erfolgen kann.

Sofern die Nennströme eine Größe überschreiten, welche durch die "internen" Stromsensoren und/oder Spannungssensoren nicht mehr erfasst werden können, kann folglich eine Ermittlung des Stromwertes und/oder Spannungswertes der zu überwachenden Leitungen vollständig über die externen Stromsensoren und/oder externen Spannungssensoren erfolgen. Bei einer Überwachung mittels der externen Stromsensoren und/oder externen Spannungssensoren sind vorzugsweise die im ASIC angeordneten nichtgenutzten Stromsensoren und/oder die in der Leiterplatte integrierten nichtgenutzten Spannungssensoren deaktivierbar. Die "internen" Stromsensoren und/oder Spannungssensoren des Messsystems sind vorzugsweise für Nennströme bis ca. 20 Ampere ausgelegt. Durch das Koppeln von externen Strom- und Spannungssensoren mit dem Messsystem kann das Messsystem folglich auch für Nennströme > 20 Ampere verwendet werden. Auf diese Weise kann eine äußerst vielfältige Nutzung des Messsystems erfolgen.

Ebenso ist es denkbar, dass die mindestens eine Phase des zu überwachenden Systems jeweils mittels eines Spannungsteilers abgebildet und letztendlich von dem zugehörigen Spannungssensor des Messsystems ausgewertet wird. Über eine durch den Spannungsteiler bereitgestellte Leiterpotentialphase, welche zu dem Spannungssensor geführt wird, kann letztendlich die zu überwachende Phase abgebildet werden.

In einer weiteren vorteilhaften Ausführungsform der Erfindung kann das Messmodul den Leistungsfaktor (cosϕ), die Wirkleistung, die Scheinleistung, die Blindleistung und/oder einen den Leistungsfaktor, die Wirkleistung, die Scheinleistung und/oder die Blindleistung charakterisierenden Wert bezüglich der mindestens einen Phase ermitteln und über das Ausgabemittel ausgeben. Anhand dieser Werte kann die durch die mindestens eine Phase mit Energie versogt Anlage überwacht und analysiert werden.

Erfindungsgemäss wird der Signalweiterverarbeitungsbaustein anhand der ermittelten Strom- und/oder Spannungswerte eine Überlast und/oder einen Kurzschluss einer über die mindestens eine Phase versorgten Anlage ermitteln.

Ferner können vorzugsweise durch das Messsystem die Phasennulldurchgänge von Strom und Spannung ermittelt werden.
In einer weiteren vorteilhaften Ausführungsform der Erfindung umfasst der ASIC ferner den Signalweiterverarbeitungsbaustein. Auf diese Weise kann ein besonders kostengünstiges Messsystem realisiert werden.

In einer weiteren vorteilhaften Ausführungsform der Erfindung ist das Messmodul, insbesondere der Signalerfassungsbaustein, über Parametriermittel, insbesondere Parameterpins und/oder eine serielle Schnittstelle, parametrierbar. Über die Parametriermittel kann vorzugsweise insbesondere ein Verhalten des Messmoduls hinsichtlich Grenzwerte der zu überwachenden Ströme und Spannungen, eine Sensorauswahl und/oder eine Phasenanzahl eingestellt werden. Ein Messsystem, welches beispielsweise drei Phasen überwachen kann, kann beispielsweise über das Parametriermittel derart eingestellt werden, dass lediglich die Stromsensoren und der Spannungssensor einer Phase aktiv sind und die anderen Strom- und Spannungssensoren deaktiviert sind.

In einer vorteilhaften Ausführungsform der Erfindung wird die mindestens eine Phase jeweils durch eine Leiterpotentialphase gebildet. Mittels eines Spannungsteilers wird beispielsweise eine reduzierte Spannung dem Messsystem über die Leiterpotentialphase zugeführt, so dass durch eine Analyse der Leiterpotentialphase die zu überwachenden Anlage überwacht werden kann. Die Leiterpotentialphase spiegelt folglich die tatsächliche Versorgungsleitung des zu überwachenden Verbrauchers wieder.

In einer weiteren vorteilhaften Ausführungsform der Erfindung ist in der Leiterplatte die mindestens eine Phase geführt und der Signalerfassungsbaustein ist auf der Leiterplatte derart positioniert, dass die mindestens eine Phase unterhalb des Signalerfassungsbausteins geführt ist. Der von dem Signalerfassungsbaustein überdeckte Bereich der Leiterplatte einhält folglich die mindestens eine Phase. Eine durch die Phase geführte orthogonal zur Leiterplatte ausgerichtete Gerade kann folglich den Signalerfassungsbaustein schneiden.

In Bezug zum Spannungssensor kann vorzugsweise eine durch die Phase geführte orthogonal zur Leiterplatte ausgerichtete Gerade einen Teil des Spannungssensors, welcher die Phase überwacht, schneiden.

In einer weiteren vorteilhaften Ausführungsform der Erfindung umfasst das Messsystem einen Isolierblock, in welchem die mindestens eine Phase geführt ist, wobei die Leiterplatte eine erste und eine zweite Seitenfläche aufweist, wobei die erste Seitenfläche der zweiten Seitenfläche gegenüberliegend angeordnet ist, wobei der Signalerfassungsbaustein an der ersten Seitenfläche angeordnet ist und der Isolierblock an der zweiten Seitenfläche angeordnet ist, wobei der Signalerfassungsbaustein gegenüber dem Isolierblock auf der Leiterplatte derart positioniert ist, dass die mindestens eine Phase unterhalb des Signalerfassungsbausteins geführt ist. Eine durch die Phase geführte orthogonal zur zweiten Seitenfläche der Leiterplatte und/oder dem Isolierblock ausgerichtete Gerade kann folglich den Signalerfassungsbaustein schneiden. Durch die Integration der Phase in einen Isolierblock kann ein System welches mit hohen Strömen versorgt wird ebenso sicher überwacht und analysiert werden, so dass es zu keiner Beschädigung der Leiterplatte bzw. anderer Bausteine kommen kann.

In einer weiteren vorteilhaften Ausführungsform der Erfindung weist die erste Seitenfläche eine Vertiefung auf, so dass der Signalerfassungsbaustein zumindest teilweise in der Leiterplatte integriert ist. Die orthogonal zur Leiterplatte ausgerichteten Seitenflächen des Signalerfassungsbausteins werden zumindest teilweise von der Leiterplatte umrahmt. Der Signalerfassungsbaustein ist folglich in einen tiefgefrästen Bereich der Leiterplatte eingesetzt. Vorzugsweise ist der Signalerfassungsbaustein mit der zur Leiterplatte gerichteten Seitenfläche vollständig in der Vertiefung der Leiterplatte platziert. Auf diese Weise wird der Abstand zwischen den Stromsensoren und der/den zu überwachenden Phasen so gering wie möglich gehalten, so dass eine verbesserte Strommessung erfolgen kann. Es ist ebenso denkbar, dass sofern die Phasenführung innerhalb der Leiterplatte erfolgt die Leiterplatte für den Signalerfassungsbaustein eine Vertiefung aufweist.

In einer weiteren vorteilhaften Ausführungsform der Erfindung umfasst ein Verbraucherabzweig das Messsystem, wobei mit dem Messsystem mindestens eine Phase des Verbraucherabzweigs überwachbar ist. Der Verbraucherabzweig ist das System mit der mindestens einen Phase, welches durch das Messsystem überwacht wird. Die mindestens eine Phase des Verbraucherabzweigs repräsentiert letztendlich die Phase einer mit dem Verbraucherabzweig verbundenen Anlage, so dass durch die Überwachung der mindestens einen Phase des Verbraucherabzweigs die Anlage überwacht wird.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung einer Draufsicht auf ein Messsystem, mit welchem drei Phasen eines Systems überwachbar sind,
- FIG 2: eine schematische Darstellung einer Seitenansicht einer Ausführungsform eines Messsystems zur Überwachung dreier Phasen eines Systems,
- FIG 3: eine schematische Darstellung einer Seitenansicht einer weiteren Ausführungsform eines Messsystems zur Überwachung dreier Phasen eines Systems,
- FIG 4: eine schematische Darstellung einer Seitenansicht einer weiteren Ausführungsform eines Messsystems zur Überwachung dreier Phasen eines Systems, und
- FIG 5: eine perspektivische Ansicht eines Teils der in FIG 3 gezeigten Ausführungsform.

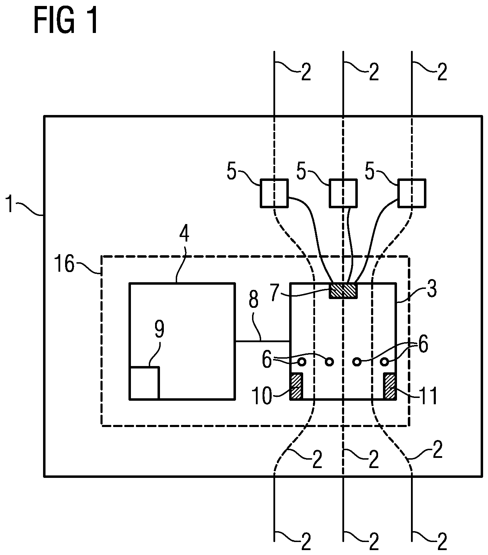

FIG 1 zeigt eine schematische Darstellung einer Draufsicht auf ein Messsystem 1, mit welchem drei Phasen 2 eines Systems überwachbar sind. Das System ist hierbei ein Verbraucherabzweig durch welchen drei Phasen 2, welche der Energieversorgung einer mit dem Verbraucherabzweig verbundenen Anlage dienen, geführt werden. Die drei Phasen 2 des Verbraucherabzweigs spiegeln letztendlich die Energieversorgungsleitungen der mit dem Verbraucherabzweig verbunden Anlage wieder, so dass durch die Überwachung der drei Phasen 2 des Verbraucherabzweigs letztendlich die mit dem Verbraucherabzweig verbundene Anlage überwacht werden kann. Damit eine Überwachung der drei Phasen 2 durch den Verbraucherabzweig erfolgen kann werden die drei Phasen 2 des Verbraucherabzweigs zu dem Messsystem geführt und überwacht.

Das Messsystem ist hierbei Bestandteil des Verbraucherabzweiges mit welchem die Anlage überwacht wird. Damit durch den Verbraucherabzweig eine Optimierung der Verbrauchswerte der Anlage, eine Kontrolle des Betriebszustandes der Anlage sowie eine Überwachung hinsichtlich einer Überlast oder eines Kurzschlusses bei der Anlage erfolgen kann, umfasst der Verbraucherabzweig das erfindungsgemäße Messsystem. Mithilfe des Messsystems können insbesondere Stromwerte, Spannungswerte sowie der Phasenwinkel der einzelnen Phasen 2 ermittelt und letztendlich ausgewertet werden. Anhand dieser Auswertung können durch das Messsystem insbesondere serielle Daten sowie digitale Signale ausgegeben werden, so dass die erwünschte Überwachung der Anlage durch das Messsystem und somit durch den Verbraucherabzweig erfolgen kann.

Das Messsystem umfasst hierfür ein Messmodul 16, welches den Signalerfassungsbaustein 3 und den Signalweiterverarbeitungsbaustein 4 umfasst, sowie eine Leiterplatte 1, auf welcher vorzugsweise der Signalerfassungsbaustein 3 und der Signalweiterverarbeitungsbaustein 4 befestigt sind. Der Signalerfassungsbaustein 3 und der Signalweiterverarbeitungsbaustein 4 sind über eine Verbindungsleitung 8 miteinander elektrisch leitend verbunden. Diese Verbindungsleitung 8 kann durch die Leiterplatte 1 ausgebildet sein.

Durch das abgebildete Messsystem kann ein System, welches bis zu drei Phasen 2 umfasst, überwacht werden. Hierfür umfasst die Leiterplatte 1 drei Spannungssensoren 5, welche in der Leiterplatte 1 integriert sind. Diese drei Spannungssensoren 5 werden vorzugsweise vollständig von der Leiterplatte 1 umgeben. Jeder Phase 2 ist ein Spannungssensor 5, vorzugsweise ein kapazitiver Spannungssensor 5, zugeordnet. Folglich kann mittels der Spannungssensoren 5 jeweils ein Spannungswert der zugehörigen Phase 2 ermittelt werden. Jeder der Spannungssensoren 5 ist über den Spannungssensoranschluss 7 des Signalerfassungsbausteins 3 mit dem Signalerfassungsbaustein 3 verbunden. Der Signalerfassungsbaustein 3 umfasst vier Stromsensoren 6, mit welchen ein Stromwert der einzelnen Phasen 2 ermittelt werden kann. Zur Ermittlung des Stromwertes einer Phase 2 werden jeweils zwei Stromsensoren 6 benötigt. Die einzelnen Stromsensoren 6 sind insbesondere Stromerfassungs-Hallsensoren 6.

Der Stromwert ist insbesondere ein den Strom der Phase charakterisierender Wert. Der Spannungswert ist insbesondere ein die Spannung der Phase charakterisierender Wert.

Im Eintrittsbereich sowie im Austrittsbereich der drei Phasen 2 in die Leiterplatte 1 werden die einzelnen Phasen 2 im Vergleich zu dem Bereich, in welchem die Phasen 2 unterhalb des Signalerfassungsbausteins 3 und insbesondere der Stromsensoren 6 geführt werden, weiter beabstandet voneinander geführt. Im Bereich des Signalerfassungsbausteins 3 und insbesondere im Bereich der Stromsensoren 6 erfolgt somit eine gebündelte Führung der einzelnen Phasen 2 zueinander. Die einzelnen Phasen 2 werden hierbei direkt innerhalb der Leiterplatte 1 geführt. Alternativ hierzu können die einzelnen Phasen 2 auch unterhalb der Leiterplatte 1 z.B. innerhalb eines Isolierblocks geführt werden. In der Draufsicht sind folglich die einzelnen Stromsensoren 6 neben den einzelnen Phasen 2 angeordnet wohingegen die Spannungssensoren 5 jeweils eine Phase 2 überdecken. Die durch den Spannungssensor 5 überdeckte Phase 2 wird letztendlich von dem Spannungssensor 5 überwacht.

Die Spannungssensoren 5 sind außerhalb des von dem Signalerfassungsbaustein 3 überdeckten Bereichs in der Leiterplatte 1 angeordnet. In der Figur 1 ist die Führung der Phasen 2 zueinander in diesem Bereich bereits weiter beabstandet als im Beriech der Stromsensoren 6. Es ist aber auch denkbar, dass die Beabstandung der Phasen 2 im Bereich der Spannungssensoren 5 gleich der Beabstandung der Phasen 2 im Bereich der Stromsensoren 6 ist.

Der Signalerfassungsbaustein 3 umfasst die Stromsensoren 6, den Spannungsanschluss 7, über welchen die Spannungssensoren 5 mit dem Signalerfassungsbaustein 3 gekoppelt werden, ein Anschlussmittel 10 und ein Parametriermittel 11.

Über das Anschlussmittel 10 können externe Stromsensoren wie z.B. ein Stromwandler, eine Rogowskispulen oder ein Shunt mit dem Signalerfassungsbaustein 3 gekoppelt werden. Hierdurch kann durch das Messsystem ebenso eine Stromerfassung sowie Analyse außerhalb der für die internen Stromsensoren 6 zulässigen Bereiche bereitgestellt werden. Hierfür können vorzugsweise die internen Stromsensoren 6 deaktiviert werden. Ebenso ist es denkbar, dass eine externe Spannungserfassung mit dem Messsystem koppelbar ist, so dass eine anschließende Analyse der ermittelten Spannungswerte über das Messsystem erfolgen kann.

Über das Parametriermittel 11 können insbesondere der Signalerfassungsbaustein 3 und/oder der Signalweiterverarbeitungsbaustein 4 parametriert werden. Erfolgt beispielsweise lediglich die Überwachung eines einphasigen Systems, so können vorzugsweise durch das Parametriermittel 11 die nichtverwendeten Strom- und Spannungssensoren 5,6 deaktiviert werden. Ebenso kann vorzugsweise über das Parametriermittel 11 die "internen" Stromsensoren deaktiviert werden, sofern externe Stromsensoren mit dem Signalerfassungsbaustein 3 gekoppelt und genutzt werden.

Der Signalerfassungsbaustein 3 wird durch einen ASIC realisiert. Auf diese Weise kann eine kostengünstige Fertigung sowie ein zuverlässiger Signalerfassungsbaustein 3 bereitgestellt werden.

Der Signalweiterverarbeitungsbaustein 4 umfasst ein Ausgabemittel 9 über welches mittels serieller Daten, insbesondere Strom-, Spannungs-, Leistungs- und Diagnosewerte, und mittels digitaler Signale für Steuerungszwecke, insbesondere Signale, welche einen Kurzschluss, eine Überlast und einen Phasennulldurchgang des Stroms und der Spannung hinsichtlich der überwachten mindestens einen Phase 2 charakterisieren, ausgebbar sind. Das Ausgabemittel 9 umfasst vorzugsweise für die seriellen Daten und/oder für die digitalen Signale einen separaten Ausgang oder separate Ausgänge.

Mittels des Messsystems kann somit durch die Überwachung der drei Phasen 2 alle relevanten Werte (Stromwert, Spannungswert, CosPhi) bezüglich der durch den Verbraucherabzweig überwachten Anlage ermittelt und analysiert werden, so dass bei der durch den Verbraucherabzweig überwachten Anlage eine Analyse hinsichtlich der Optimierung dieser Anlage, eine Kontrolle des Betriebszustandes dieser Anlage und eine Überwachung hinsichtlich einer Überlast bzw. eines Kurzschluss dieser Anlage ermöglicht wird. Durch das Messsystem und somit durch den Verbraucherabzweig kann ein äußerst breites Einssatzspektrum abgedeckt werden, ohne, dass anlagenspezifische Messsystem oder Verbraucherabzweige hergestellt werden müssen.

Dadurch, dass die Weiterverbreitung der Stromwerte sowie Spannungswerte in dem Signalweiterverarbeitungsbaustein 4 erfolgt, kann je nach Leistungsbedarf der Signalerfassungsbaustein 3 mit einem geeigneten Signalweiterverarbeitungsbaustein 4 gekoppelt werden. Ein flexibler Einsatz kann hierdurch gewährleistet werden. Der Signalweiterverarbeitungsbaustein 4 umfasst insbesondere einen Mikrokontroller, welcher je nach Leistungsbedarf dimensioniert ist. Durch den zweigeteilten Aufbau kann ein äußerst vielfältiges Messsystem bereitgestellt werden, mit welchem eine Analyse hinsichtlich der Optimierung einer mit dem Verbraucherabzweig verbundenen Anlage, eine Kontrolle des Betriebszustandes der Anlage und eine Überwachung hinsichtlich einer Überlast bzw. eines Kurzschluss der Anlage ermöglicht wird.

Es ist ebenso denkbar, dass der Signalweiterverarbeitungsbaustein 4 und der Signalerfassungsbaustein 3 als ein ASIC Baustein realisiert ist.

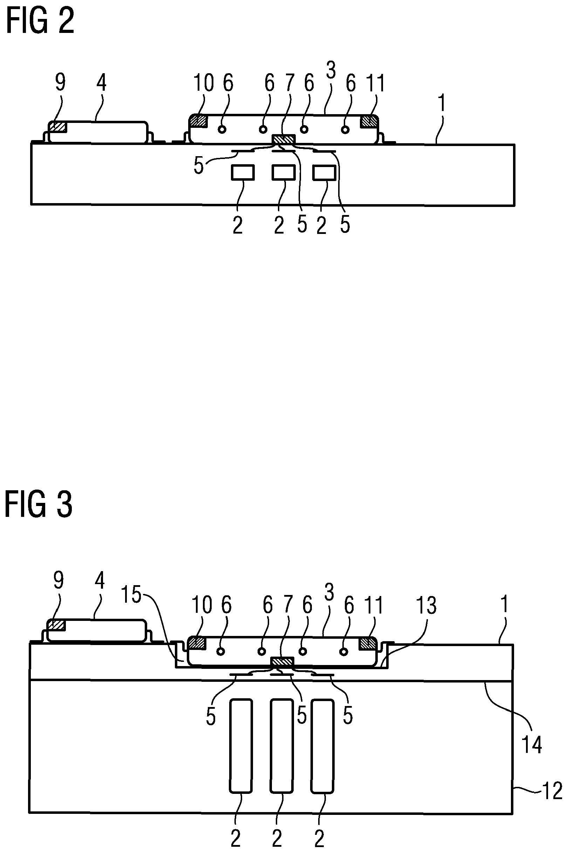

FIG 2 zeigt eine schematische Darstellung einer Seitenansicht einer Ausführungsform eines Messsystems zur Überwachung dreier Phasen 2 eines Systems. Das System ist hierbei vorzugsweise ein Verbraucherabzweig, wobei über die drei Phasen 2 des Verbraucherabzweiges eine mit dem Verbraucherabzweig verbundene Analage überwacht wird. Das Messsystem umfasst hierbei ein Messmodul, umfassend einen Signalerfassungsbaustein 3 sowie einen Signalweiterverarbeitungsbaustein 4, und eine Leiterplatte 1, in welcher drei Spannungssensoren 5 integriert sind.

Die drei Phasen 2 sind in diesem Ausführungsbeispiel innerhalb der Leiterplatte 1 geführt. Ebenso sind innerhalb der Leiterplatte 1 drei kapazitive Spannungssensoren 5 integriert, so dass je Spannungssensor 5 die Spannung einer Phase 2 ermittelt werden kann. Auf einer Seitenfläche der Leiterplatte 1 ist der Signalerfassungsbaustein 3 und der Signalweiterverarbeitungsbaustein 4 angeordnet. Der als ASIC Baustein ausgebildete Signalerfassungsbaustein 3 ist elektrisch leitend mit dem Signalweiterverarbeitungsbaustein 4 verbunden.

Die drei Spannungssensoren 5 sind vorzugsweise außerhalb des durch den Signalerfassungsbaustein 3 überdeckten Bereichs der Leiterplatte 1 angeordnet, so dass eine ungestörte Ermittlung eines Spannungswertes erfolgen kann.

Der Signalerfassungsbaustein 3 umfasst vier Stromsensoren 6, insbesondere vier Stromerfassungs-Hallsensoren 6, ein Anschlussmittel 10, ein Spannungssensoranschluss 7 und ein Parametriermittel 11. Mittels der Stromsensoren 6 kann ein Stromwert der einzelnen Phasen 2 ermittelt werden. Je Phase 2 werden zwei Stromssensoren 6 zur Ermittlung des Stromwertes benötigt. Über das Anschlussmittel 10 können externe Stromsensoren an den Signalerfassungsbaustein 3 angeschlossen werden, so dass ein Stromwert der zu überwachenden Phasen 2 über externe Stromsensoren ermittelte werden kann. Externe Stromsensoren können beispielsweise Stromwandler, Rogowskispulen oder Shunts sein, mit denen ein Stromwert der zu analysierenden Phase ermittelt werden kann. Über das Parametriermittel 11 kann der Signalerfassungsbaustein 3 parametriert werden, so dass beispielsweise ein aktivieren bzw. deaktivieren der "internen" Stromsensoren 6 erfolgen kann. Erfolgt die Ermittlung eines Stromwertes der einzelnen Phasen 2 über die externen Stromsensoren, so können beispielsweise die "internen" Stromsensoren 6 deaktiviert werden. Ebenso ist es vorzugsweise möglich die einzelnen Stromsensoren 6 und die einzelnen Spannungssensoren 5 in Abhängigkeit der zu überwachenden Phasen 2 zu aktivieren bzw. zu deaktivieren. Soll beispielsweise lediglich eine Phase 2 überwacht werden, so können über das Parametriermittel 10 jeweils zwei Stom- und Spannungssensoren 5,6 deaktiviert werden, so dass lediglich der Stom- und Spannungssensor 5,6 der zu überwachenden Phase aktiv ist. Mittels des Spannungssensoranschlusses 7 sind die drei Spannungssensoren 5 vorzugsweise über Pins mit dem Signalerfassungsbaustein 3 verbunden, so dass dem Signalerfassungsbaustein 3 die einzelnen Spannungswerte der Phasen 2 zuführbar sind.

Die Phasenführung der drei Phasen 2 erfolgt derart, dass jeweils eine Phase 2 unterhalb eines ebenso in der Leiterplatte 1 integrierten Spannungssensors 5 und mittig unterhalb zwei Stromsensoren 6 erfolgt. Vorzugsweise erfolgt im Beriech des Signalerfassungsbausteins 3 die Phasenführung gebündelt. Die einzelnen Phasen 2 werden hierbei galvanisch getrennt zu dem Messmodul und den Spannungssensoren 5 geführt.

Über den Signalerfassungsbaustein 3 können folglich die Strom- und Spannungswerte der einzelnen Phasen 2 ermittelt werden. Ferne kann anhand dieser Daten der cosϕ der einzelnen Phasen 2 ermittelt werden. Durch den Signalerfassungsbaustein 3 erfolgt folglich die Ermittlung relevanter Werte der einzelnen Phasen 2 welche letztendlich den Zustand der zu überwachenden Anlage wiederspiegeln. Diese Daten werden seitens des Signalweiterverarbeitungsbausteins 4 ausgewertet, so dass eine Analyse hinsichtlich der Optimierung einer mit dem Messsystem verbundenen Anlage, eine Kontrolle des Betriebszustandes der Anlage und eine Überwachung hinsichtlich einer Überlast bzw. eines Kurzschluss der Anlage ermöglicht wird.

Der Signalweiterverarbeitungsbaustein 4 umfasst Ausgabemittel, mit welchen serielle Daten, insbesondere Strom-, Spannungs-, Leistungs- und Diagnosewerte, und digitale Signale für Steuerungszwecke, insbesondere Signale, welche hinsichtlich der überwachten drei Phasen 2 einen Kurzschluss, eine Überlast und einen Phasennulldurchgang des Stroms und der Spannung charakterisieren, ausgebbar sind. Über das Messsystem kann folglich eine umfassende Analyse der Anlage erfolgen. Das Messmodul kann anhand der Ermittelten Strom- und Spannungswerte über das Ausgabemittel 9 den Leistungsfaktor (cosϕ), die Wirkleistung, die Scheinleistung, die Blindleistung und/oder einen den Leistungsfaktor, die Wirkleistung, die Scheinleistung und/oder die Blindleistung charakterisierenden Wert bezüglich der drei Phase 2 ermitteln und ausgeben.

Vorzugsweise werden für kleine Nennströme (bis ca. 6,0 A) die drei Phasen 2 (Leiter) des zu überwachenden Hauptstromkreises des Verbraucherabzweigs innerhalb der Leiterplatte 1 geführt. Der Signalerfassungsbaustein 3 wird direkt oberhalb der drei Phasen 2 platziert. Der nutzbare Strombereich wird durch die maximal verfügbaren Cu-Dicken der Leiterplatte 1, die zulässige Kurzzeitbelastbarkeit der Leiterbahnen im Kurzschlussfall in Verbindung mit dem jeweils zugeordneten Kurzschlussschutzelement (Sicherungen, Leistungsschalter) begrenzt.

Für die Strommessung werden die im ASIC (Signalerfassungsbaustein 3) integrierten Stromsensoren 6 genutzt. Die Spannungserfassung erfolgt mittels oberhalb der drei Phasen 2 (Leiter) angeordneter kapazitiver Spannungssensoren 5.

Diese Aufbauvariante stellt die i.d.R. kostengünstigste Lösung dar, weil z.B. in elektronischen Verbraucherabzweigen bereits vorhandene Leiterplatten 1 nur entsprechend neu ausgestaltet werden müssen.

FIG 3 zeigt eine schematische Darstellung einer Seitenansicht einer weiteren Ausführungsform eines Messsystems zur Überwachung dreier Phasen 2 eines Systems. Hierbei erfolgt im Vergleich zur Figur 2 die Führung der drei Phasen 2 nicht in der Leiterplatte 1 sondern in einem Isolierblock 12. Ferner weist die Leiterplatte 1 eine Vertiefung 15 auf, in welcher der Signalerfassungsbaustein 3 platziert ist. Hierdurch wird der Abstand der Stromsensoren 6 zu den drei Phasen 2 so gering wie möglich gehalten, so dass eine verbesserte Strommessung erfolgen kann. Die Leiterplatte 1 weist eine erste Seitenfläche 13 sowie eine zweite Seitenfläche 14 auf. Die zweite Seitenfläche 14 liegt unmittelbar am Isolierblock 12 an, wohingegen auf der ersten Seitenflache 13 der Signalerfassungsbaustein 3 und der Signalweiterverarbeitungsbaustein 4 positioniert ist. Dadurch, dass die drei Phasen 2 innerhalb des Isolierblocks 12 geführt werden, können höhere Nennströme analysiert werden.

Für Nennströme von > 3A bis ca. 40 A werden vorzugsweise in dem Isolierblock 12 eingegossene Cu-Flachleiter 2 (Phasen) genutzt. Der Signalerfassungsbaustein 3 wird in die tiefgefräste Leiterplatte 1 eingesetzt, welche direkt oberhalb des Bereiches des Isolierblocks 12, welcher die drei Phasen 2 führt, montiert wird.

Die Spannungserfassung erfolgt wiederum mittels in der Leiterplatte 1 und oberhalb der Hauptstromkreisleiter (Phasen 2) angeordneter kapazitiver Spannungssensoren 5.

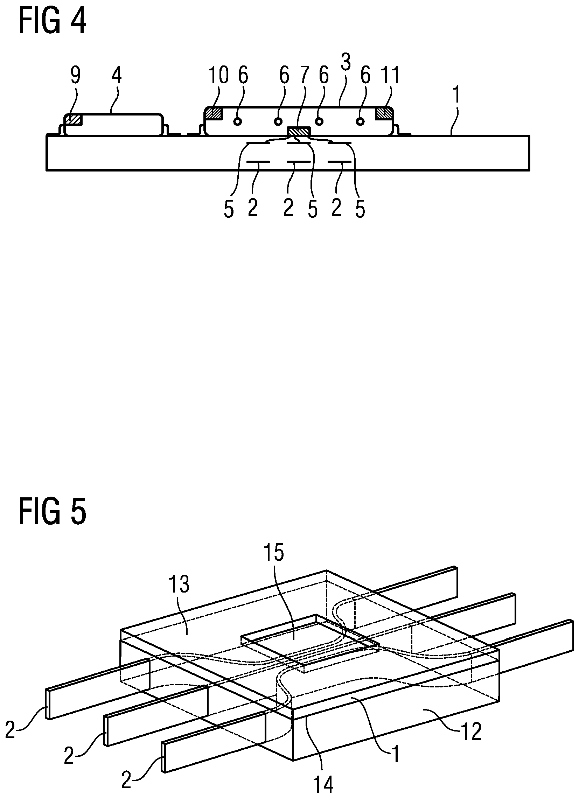

FIG 4 zeigt eine schematische Darstellung einer Seitenansicht einer weiteren Ausführungsform eines Messsystems zur Überwachung dreier Phasen 2 eines Systems. Hierbei werden im Vergleich zur Figur 2 die drei Phasen 2 durch drei Leiterpotentialphasen 2 dem Messsystem zugeführt. Mittels eines Spannungsteilers wird dem Messsystem über die Leiterpotentialphasen 2 eine reduzierte Spannung zugeführt, so dass durch eine Analyse der Leiterpotentialphasen 2 die zu überwachenden Anlage überwacht werden kann. Die Leiterpotentialphasen 2 spiegeln folglich die tatsächliche Versorgungsleitung der zu überwachenden Anlage wieder. Ferner erfolg in dieser Ausführungsform die Ermittlung des Stromwertes der einzelnen Phasen nicht über die im Signalerfassungsbaustein 3 integrierten Stromsensoren 6 sondern über externe Stromssensoren, welche über das Anschlussmittel mit dem Signalerfassungsbaustein 3 verbunden sind. Die externen Stromsensoren ermitteln den Stromwert der einzelnen Phasen außerhalb des Signalerfassungsbaustein 3 und führen den ermittelten Stromwert dem Signalerfassungsbaustein 3 über das Anschlussmittel 10 zu. Die internen Stromsensoren 6 sind hierbei vorzugsweise deaktiviert.

Zur Messung von Nennströmen > 40 A werden die im ASIC (Signalerfassungsbaustein 3) integrierten Sensorelemente 6 deaktiviert. Die 3 Phasenströme werden über externe Sensorelemente (Stromwandler, Shunt, Rogowskispule) detektiert und an die zugeordnete Eingänge (des Anschlussmittels 10) des Signalerfassungsbausteins 3, welcher als ASIC ausgebildet ist, weitergeleitet.

Die Spannungserfassung erfolgt mittels kapazitiver Spannungssensoren 5 in der Leiterplatte 1. Die zugehörigen Leiterpotentialphasen 2 werden über externe Anschlüsse an die Netzspannung der Anlage angeschlossen.

Neben der galvanisch vom Hauptstromkreis getrennten Spannungserfassung über kapazitive Sensorflächen bietet der Signalerfassungsbaustein 3 vorzugsweise auch die Möglichkeit potentialgebundene Spannungssignale (aus der Netzspannung mittels ohmscher Spannungsteiler gewonnen) zu verarbeiten. Die direkte kapazitive Spannungserfassung ist die jedoch bei weitem kostengünstigste und platzsparendste Lösung.

FIG 5 zeigt eine perspektivische Ansicht eines Teils der in Figur 3 gezeigten Ausführungsform. Hierbei ist insbesondere die Phasenführung der drei Phasen 2 ersichtlich. Die drei Phasen werden in dem Isolierblock 12, welcher unterhalb (an der zweiten Seitenfläche 14) der Leiterplatte 1 angebracht ist zu der Vertiefung 15, welche an der ersten Seitenfläche 13 der Leiterplatte 1 vorliegt, geführt. Innerhalb dieser Vertiefung 15 wird der Signalerfassungsbaustein platziert, so dass die Beabstandung zwischen den Stromsensoren und den einzelnen Phase 2 so gering wie möglich gehalten wird. Im Bereich der Vertiefung 15 (der von der Vertiefung 15 überdeckte Bereich des Isolierblocks 12) erfolgt eine Bündelung der Phasenführung, d.h. die Phasen 2 sind innerhalb des Isolierblocks 12 im Bereich der Vertiefung 15 näher zueinander beabstandet als außerhalb des von der Vertiefung 15 überdeckten Bereichs. Die einzelnen Spannungssensoren können sowohl unterhalb des von der Vertiefung 15 gebildeten Bereichs als auch bevorzugt außerhalb des von der Vertiefung gebildeten Bereichs innerhalb der Leiterplatte 1 platziert werden.

## Patentansprüche

1. Messsystem, welches der Überwachung mindestens einer Phase (2) eines Systems auf eine Überlast und/oder einen Kurzschluss dient, mit einem auf einer Leiterplatte (1) angeordneten Messmodul (16), wobei das Messmodul (16) einen Signalerfassungsbaustein (3) und einen Signalweiterverarbeitungsbaustein (4) umfasst und der Signalerfassungsbaustein (3) durch einen ASIC ausgebildet ist, wobei je zu überwachende Phase (2) die Leiterplatte (1) einen Spannungssensor (5) und der Signalerfassungsbaustein (3) Stromsensoren (6) und einen mit dem Spannungssensor (5) elektrisch leitend verbunden Spannungssensoranschluss (7) umfasst, wobei über die Stromsensoren (6) eine Ermittlung eines Stromwertes und über den Spannungssensor (5) eine Ermittlung eines Spannungswertes der zu überwachenden Phase (2) erfolgen kann, wobei der Signalweiterverarbeitungsbaustein (4) mit dem Signalerfassungsbaustein (3) verbunden ist und ermittelte Strom- und Spannungswerte auswertet, wobei der Signalweiterverarbeitungsbaustein (4) Ausgabemittel (9) umfasst, mit welchen serielle Daten und digitale Signale für Steuerungszwecke ausgebbar sind, wobei der Signalweiterverarbeitungsbaustein (4) derart ausgestaltet ist, dass er anhand der ermittelten Strom- und/oder Spannungswerte eine Überlast und/oder einen Kurzschluss einer über die mindestens eine Phase (2) versorgten Anlage ermittelt.

2. Messsystem nach Anspruch 1, wobei die Stromsensoren (6) durch im ASIC integrierte Stromerfassungs-Hallsensoren (6) ausgebildet sind.

3. Messsystem nach einem der vorhergehenden Ansprüche, wobei der mindestens eine Spannungssensor (5) außerhalb des von dem Signalerfassungsbaustein (3) überdeckten Bereichs der Leiterplatte (1) angeordnet ist.

4. Messsystem nach einem der vorhergehenden Ansprüche, wobei der mindestens eine Spannungssensor (5) innerhalb der Leiterplatte (1) angeordnet ist.

5. Messsystem nach einem der vorhergehenden Ansprüche, wobei der Spannungssensor (5) ein kapazitiver Spannungssensor (5) ist.

6. Messsystem nach einem der vorhergehenden Ansprüche, wobei die mindestens eine zu überwachende Phase (2) des zu überwachenden Systems jeweils galvanisch getrennt von ihren Stromsensoren (6) und ihrem Spannungssensoranschluss (7), insbesondere ihrem Spannungssensor (5), ist.

7. Messsystem nach einem der vorhergehenden Ansprüche, wobei das Messsystem zur Überwachung eines mindestens dreiphasigen Systems ausgebildet ist.

8. Messsystem nach einem der vorhergehenden Ansprüche, wobei das Messmodul (16), insbesondere der Signalerfassungsbaustein (3), mindestens ein Anschlussmittel (10) zum Anschließen eines externen Stromsensors zur Ermittlung eines Stromwertes der mindestens einen Phase (2) des Systems umfasst.

9. Messsystem nach einem der vorhergehenden Ansprüche, wobei das Messmodul (16) den Leistungsfaktor (cosϕ), die Wirkleistung, die Scheinleistung, die Blindleistung und/oder einen den Leistungsfaktor, die Wirkleistung, die Scheinleistung und/oder die Blindleistung charakterisierenden Wert bezüglich der mindestens einen Phase (2) ermitteln und über das Ausgabemittel (9) ausgeben kann.

10. Messsystem nach einem der vorhergehenden Ansprüche, wobei das Messsystem mehrere Phasen (2) des Systems auf eine Überlast und/oder einen Kurzschluss überwacht, wobei die Phasen (2) bei einer Draufsicht auf den Signalerfassungsbaustein (3) und die Leiterplatte (1) im Bereich des Signalerfassungsbausteins (3) gebündelt geführt und außerhalb des Signalerfassungsbausteins (3) innerhalb der Leiterplatte (1) oder innerhalb eines Isolierblocks mit einem weiteren Abstand zueinander geführt werden.

11. Messsystem nach einem der vorhergehenden Ansprüche, wobei der ASIC ferner den Signalweiterverarbeitungsbaustein (4) umfasst.

12. Messsystem nach einem der vorhergehenden Ansprüche, wobei das Messmodul (16), insbesondere der Signalerfassungsbaustein (3), über Parametriermittel (11), insbesondere Parameterpins und/oder eine serielle Schnittstelle, parametrierbar ist, wobei mittels des Parametriermittels (11) die einzelnen Stromsensoren (6) des Signalerfassungsbausteins (3) und die einzelnen Spannungssensoren (5) deaktivierbar sind.

13. Messsystem nach einem der vorhergehenden Ansprüche, wobei in der Leiterplatte (1) die mindestens eine Phase (2) geführt ist und der Signalerfassungsbaustein (3) auf der Leiterplatte (1) derart positioniert ist, dass die mindestens eine Phase (2) unterhalb des Signalerfassungsbausteins (3) geführt ist.

14. Messsystem nach einem der Ansprüche 1 bis 12, wobei das Messsystem einen Isolierblock (12) umfasst, in welchem die mindestens eine Phase (2) geführt ist, wobei die Leiterplatte (1) eine erste und eine zweite Seitenfläche (13, 14) aufweist, wobei die erste Seitenfläche (13) der zweiten Seitenfläche (14) gegenüberliegend angeordnet ist, wobei der Signalerfassungsbaustein (3) an der ersten Seitenfläche (13) angeordnet ist und der Isolierblock (12) an der zweiten Seitenfläche (14) angeordnet ist, wobei der Signalerfassungsbaustein (3) gegenüber dem Isolierblock auf der Leiterplatte (1) derart positioniert ist, dass die mindestens eine Phase (2) unterhalb des Signalerfassungsbausteins (3) geführt ist.

15. Messsystem nach Anspruch 14, wobei die erste Seitenfläche (13) eine Vertiefung (15) aufweist, so dass der Signalerfassungsbaustein (3) zumindest teilweise in der Leiterplatte (1) integriert ist.

16. Verbraucherabzweig mit einem Messsystem nach einem der Ansprüche 1 bis 15, wobei der Verbraucherabzweig das System ist und mit dem Messsystem mindestens eine Phase des Verbraucherabzweigs überwachbar ist.

## Claims

1. Measuring system which serves to monitor at least one phase (2) of a system for an overload and/or a short-circuit, having a measuring module (16) arranged on a printed circuit board (1), wherein the measuring module (16) comprises a signal acquisition component (3) and a signal further-processing component (4) and the signal acquisition component (3) is embodied by means of an ASIC, wherein, for each phase (2) requiring to be monitored, the printed circuit board (1) comprises a voltage sensor (5) and the signal acquisition component (3) comprises current sensors (6) and a voltage sensor terminal (7) connected to the voltage sensor (5) in an electrically conducting manner, wherein a current value can be determined via the current sensors (6) and a voltage value of the phase (2) requiring to be monitored can be determined via the voltage sensor (5), wherein the signal further-processing component (4) is connected to the signal acquisition component (3) and evaluates determined current and voltage values, wherein the signal further-processing component (4) comprises output means (9) which enable serial data and digital signals to be output for control purposes, wherein the signal further-processing component (4) is configured such that it determines an overload and/or a short-circuit of an installation supplied by way of the at least one phase (2) on the basis of the determined current and/or voltage values.

2. Measuring system according to claim 1, wherein the current sensors (6) are embodied by means of current-measuring Hall-effect sensors (6) integrated in the ASIC.

3. Measuring system according to one of the preceding claims, wherein the at least one voltage sensor (5) is arranged outside the area of the printed circuit board (1) covered by the signal acquisition component (3).

4. Measuring system according to one of the preceding claims, wherein the at least one voltage sensor (5) is arranged inside the printed circuit board (1).

5. Measuring system according to one of the preceding claims, wherein the voltage sensor (5) is a capacitive voltage sensor (5) .

6. Measuring system according to one of the preceding claims, wherein the at least one phase (2) requiring to be monitored of the system requiring to be monitored is in each case electrically isolated from its current sensors (6) and its voltage sensor terminal (7), in particular its voltage sensor (5) .

7. Measuring system according to one of the preceding claims, wherein the measuring system is embodied for the purpose of monitoring an at least three-phase system.

8. Measuring system according to one of the preceding claims, wherein the measuring module (16), in particular the signal acquisition component (3), comprises at least one connecting means (10) for connecting an external current sensor for determining a current value of the at least one phase (2) of the system.

9. Measuring system according to one of the preceding claims, wherein the measuring module (16) is able to determine the power factor (cosϕ), the effective power, the apparent power, the reactive power and/or a value characterizing the power factor, the effective power, the apparent power and/or the reactive power in terms of the at least one phase (2) and can output same via the output means (9).

10. Measuring system according to one of the preceding claims, wherein the measuring system monitors a number of phases (2) of the system for an overload and/or a short-circuit, wherein with a top view onto the signal acquisition component (3) and the printed circuit board (1) the phases (2) are routed bundled in the region of the signal acquisition component (3) and outside of the signal acquisition component (3) are routed within the printed circuit board (1) or within an insulation block at a further distance with respect to one another.

11. Measuring system according to one of the preceding claims, wherein the ASIC further comprises the signal further-processing component (4).

12. Measuring system according to one of the preceding claims, wherein the measuring module (16), in particular the signal acquisition component (3), can be parameterized via parameterizing means (11), in particular parameter pins and/or a serial interface, whereby the individual current sensors (6) of the signal acquisition component (3) and the individual voltage sensors (5) can be deactivated by means of the parameterizing means (11).

13. Measuring system according to one of the preceding claims, wherein the at least one phase (2) is routed in the printed circuit board (1) and the signal acquisition component (3) is positioned on the printed circuit board (1) in such a way that the at least one phase (2) is routed beneath the signal acquisition component (3).

14. Measuring system according to one of claims 1 to 12, wherein the measuring system comprises an insulating block (12) in which the at least one phase (2) is routed, wherein the printed circuit board (1) has a first and a second lateral surface (13, 14), wherein the first lateral surface (13) is disposed opposite the second lateral surface (14), wherein the signal acquisition component (3) is arranged on the first lateral surface (13) and the insulating block (12) is arranged on the second lateral surface (14), wherein the signal acquisition component (3) is positioned opposite the insulating block on the printed circuit board (1) in such a way that the at least one phase (2) is routed beneath the signal acquisition component (3).

15. Measuring system according to claim 14, wherein the first lateral surface (13) has a recess (15) so that the signal acquisition component (3) is at least partially integrated in the printed circuit board (1).

16. Load feeder having a measuring system according to one of claims 1 to 15, wherein the load feeder is the system and at least one phase of the load feeder can be monitored by means of the measuring system.

## Revendications

1. Système de mesure, qui sert à contrôler une surcharge et/ou un court-circuit dans au moins une phase (2) d'un système, comprenant un module (16) de mesure, monté sur une plaquette (1) à circuit imprimé, le module (16) de mesure comprenant un bloc (3) de détection de signal et un bloc (4) de retraitement du signal et le bloc (3) de détection d'un signal est constitué par un ASIC, dans lequel, pour chaque phase (2) à contrôler, la plaquette (1) à circuit imprimé comprend un capteur (5) de tension et le bloc (3) de détection d'un signal comprend des capteurs (6) de courant et une borne (7) de capteur de tension reliée d'une manière conductrice de l'électricité au capteur (5) de tension, dans lequel, par les capteurs (6) de courant, une détermination d'une valeur du courant, et par le capteur (5) de tension, une détermination d'une valeur de tension de la phase (2) à contrôler peut s'effectuer, dans lequel le bloc (4) de retraitement du signal est relié au bloc (3) de détection d'un signal et exploite des valeurs déterminées du courant et de la tension, le bloc (4) de retraitement du signal comprenant des moyens (9) d'émission, par lesquels des données en séquence et des signaux numériques peuvent être émis à des fins de commande, le bloc (4) de retraitement du signal étant conformé de manière à déterminer, à l'aide des valeurs déterminées de courant et/ou de tension, une surcharge et/ou un court-circuit d'une installation alimentée par la au moins une phase (2).

2. Système de mesure suivant la revendication 1, dans lequel les capteurs (6) de courant sont constitués par des capteurs (6) de Hall de détection du courant intégrés dans l'ASIC.

3. Système de mesure suivant l'une des revendications précédentes, dans lequel le au moins un capteur (5) de tension est disposé à l'extérieur de la région, recouverte par le bloc (3) de détection d'un signal, de la plaquette (1) à circuit imprimé.

4. Système de mesure suivant l'une des revendications précédentes, dans lequel le au moins un capteur (5) de tension est disposé au sein de la plaquette (1) à circuit imprimé.

5. Système de mesure suivant l'une des revendications précédentes, dans lequel le capteur (5) de tension est un capteur (5) de tension capacitif.

6. Système de mesure suivant l'une des revendications précédentes, dans lequel la au moins une phase (2) à contrôler du système à contrôler est séparée galvaniquement de ses capteurs (6) de courant et de sa borne (7) de capteur de tension, notamment de son capteur (5) de tension.

7. Système de mesure suivant l'une des revendications précédentes, dans lequel le système de mesure est constitué pour contrôler un système au moins triphasé.

8. Système de mesure suivant l'une des revendications précédentes, dans lequel le module (16) de mesure, notamment le bloc (3) de détection d'un signal, comprend au moins un moyen (10) de connexion pour la connexion d'un capteur de courant extérieur, afin de déterminer une valeur du courant de la au moins une phase (2) du système.

9. Système de mesure suivant l'une des revendications précédentes, dans lequel le module (16) de mesure peut déterminer le facteur de puissance (cosϕ), la puissance active, la puissance apparente, la puissance réactive et/ou une valeur caractérisant le facteur de puissance, la puissance active, la puissance apparente et/ou la puissance réactive en ce qui concerne la au moins une phase (2) et l'émettre par le moyen (9) d'émission.

10. Système de mesure suivant l'une des revendications précédentes, dans lequel le système de mesure contrôle une surcharge et/ou un court-circuit sur plusieurs phases (2) du système, les phases (2) étant guidées en faisceau en vue de dessus sur le bloc (3) de détection d'un signal et la plaquette (1) à circuit imprimé, dans la région du module (3) de détection d'un signal et à l'extérieur du bloc (3) de détection d'un signal, étant guidée au sein de la plaquette (1) à circuit imprimé ou au sein d'un bloc isolant en étant à une distance supplémentaire les unes des autres.

11. Système de mesure suivant l'une des revendications précédentes, dans lequel l'ASIC comprend, en outre, le bloc (4) de retraitement du signal.

12. Système de mesure suivant l'une des revendications précédentes, dans lequel le module (16) de mesure, notamment le bloc (3) de détection d'un signal, peut être paramétré par des moyens (11) de paramétrage, notamment par des broches de paramétrage et/ou une interface en série, dans lequel, à l'aide du moyen (11) de paramétrage, les divers capteurs (6) de courant du bloc (3) de détection d'un signal et les divers capteurs (5) de tension peuvent être désactivés.

13. Système de mesure suivant l'une des revendications précédentes, dans lequel la au moins une phase (2) passe dans la plaquette (1) à circuit imprimé et le bloc (3) de détection d'un signal est placé sur la plaquette (1) à circuit imprimé de manière à ce que la au moins une phase (2) passe en dessous du bloc (3) de détection d'un signal.

14. Système de mesure suivant l'une des revendications 1 à 12, dans lequel le système de mesure comprend un bloc (12) isolant, dans lequel passe la au moins une phase (2), la plaquette (1) à circuit imprimé ayant une première et une deuxième surfaces (13,14) latérales, la première surface (13) latérale étant disposée en opposition à la deuxième surface (14) latérale, le bloc (3) de détection d'un signal étant disposé sur la première surface (13) latérale et le bloc (12) isolant étant disposé sur la deuxième surface (14) latérale, le bloc (3) de détection d'un signal étant placé en opposition au bloc isolant sur la plaquette (1) à circuit imprimé de manière à ce que la au moins une phase (2) passe en dessous du bloc (3) de détection d'un signal.

15. Système de mesure suivant la revendication 14, dans lequel la première surface (13) latérale a une cavité (15), de manière à intégrer le bloc (3) de détection d'un signal, au moins en partie, dans la plaquette (1) à circuit imprimé.

16. Branchement de consommateur comprenant de mesure suivant l'une des revendications 1 à 15, dans lequel le branchement de consommateur est le système et, par le système de mesure, au moins une phase du branchement de consommateur peut être contrôlée.
